# EUROPEAN PATENT APPLICATION

(11) **EP 4 084 052 A1**
(43) Date of publication of application: **02.11.2022**
(21) Application number: 20913536.7
(22) Date of filing: 19.01.2020
(51) Int. Cl.: H01L 21/66, G11C 29/00

(54) **WAFER TO WAFER STRUCTURE AND TEST METHOD THEREFOR, AND HIGH BANDWIDTH MEMORY AND MANUFACTURING METHOD THEREFOR**

(71) Applicant: Huawei Technologies Co., Ltd., Shenzhen, Guangdong 518129 (CN)
(72) Inventor: FAN, Luming, Shenzhen, Guangdong 518129 (CN); LIU, Yanxiang, Shenzhen, Guangdong 518129 (CN)
(74) Representative: Maiwald Patent- und Rechtsanwaltsgesellschaft mbH
(86) International application number: PCT/CN2020/072920
(87) International publication number: WO 2021/142816

(57) **Abstract**

A wafer to wafer stacking structure and a test method therefor, and a high bandwidth memory and a production method therefor are provided, and relate to the field of semiconductor storage technologies, to resolve a problem in the conventional technology that a production yield rate of the wafer to wafer stacking structure is low and production costs of the high bandwidth memory are high. The wafer to wafer stacking structure is tested by using the test method. In the wafer to wafer stacking structure, a logic wafer (10) and a plurality of tiers of memory wafers (20) are connected through a bus (30). The bus (30) records a tier address of each memory wafer (20) in the wafer to wafer stacking structure. An addresser (40) reads probe information and a tier address that is corresponding to a to-be-tested three-dimensional tier-number address, so that a connection status of a cut unit (201) in the wafer to wafer stacking structure can be adjusted, and a tier at which a defective memory chip is located is addressed and shielded for a high bandwidth memory obtained through cutting. In this way, an actual available memory capacity in the high bandwidth memory is adjusted, and a plurality of types of high bandwidth memories with a part of capacity reduced are provided.

## Description

### TECHNICAL FIELD

This application relates to the field of semiconductor storage technologies, and in particular, to a wafer to wafer stacking structure and a test method therefor, and a high bandwidth memory and a production method therefor.

### BACKGROUND

A high bandwidth memory (High Bandwidth Memory, HBM) is a high-performance dynamic random access memory (Dynamic Random Access Memory, DRAM) based on a 3D stacking process. The high bandwidth memory is applicable to an application scenario with a high bandwidth requirement, and is usually used in combination with a high-performance graphics accelerator or a network apparatus. The high bandwidth memory is adopted as an industry standard by the JEDEC (Joint Electron Device Engineering Council, Solid State Technology Council) in 2013.

According to the high bandwidth memory produced by using the 3D stacking process, stacking and hierarchical interconnection between a multi-tier DRAM chip and a logic (logic) chip are implemented by using a through silicon via (Through Silicon Via, TSV) technology and a micro solder bump (Micro-bump) technology. In comparison with a planar structure, a storage capacity can be effectively increased without expanding a planar area. There are generally two stacking manners for producing the high bandwidth memory: a die to die (D2D, die to die stacking) manner and a wafer to wafer (W2W, wafer to wafer stacking) manner. In the die to die manner, a yield rate test can be performed on each cut unit (a chip structure before cutting and packaging, Die) on a wafer at each wafer stacked tier, to screen a KGD (Known Good Die, known good die), to improve a yield rate of a produced high bandwidth memory. However, due to process limitations and die-by-die KGD screening, improvement of interconnection density on a chip is limited, and production efficiency is low.

In the wafer to wafer manner, a yield rate test is usually performed after a plurality of tiers of wafers are all stacked. In the conventional technology, a yield rate of a wafer at each tier can generally reach about 90%. However, as a quantity of tiers of stacked wafers increases, a yield rate of a finished high bandwidth memory product geometrically decreases. In a stacked wafer structure, a cut unit that is considered as a defective product through the yield rate test cannot be removed or replaced. As a result, production costs of a good high bandwidth memory greatly increase.

### SUMMARY

This application provides a wafer to wafer stacking structure and a test method therefor, and a high bandwidth memory and a production method therefor, to resolve a problem in the conventional technology that a production yield rate of the wafer to wafer stacking structure is low and production costs of the high bandwidth memory are high.

According to a first aspect of embodiments of this application, a test method for a wafer to wafer stacking structure is provided. The test method is applied to a test machine, and the test machine is configured to test the wafer to wafer stacking structure. The wafer to wafer stacking structure includes a logic wafer and a plurality of tiers of memory wafers, where the logic wafer and the plurality of tiers of memory wafers are stacked in sequence. The logic wafer and the plurality of tiers of memory wafers are connected through a bus. The logic wafer includes a tier address port for transmitting a tier address to the plurality of tiers of memory wafers through the bus. An addresser of the test machine is configured to connect to the logic wafer. The method includes: obtaining a to-be-tested three-dimensional tier-number address, where the three-dimensional tier-number address is used to indicate a tier address corresponding to each of the plurality of tiers of memory wafers; and reading, by the addresser based on the three-dimensional tier-number address through the tier address port of the logic wafer and the bus, probe information of a memory wafer corresponding to the three-dimensional tier-number address, where the probe information is used to indicate quality of a cut unit on the memory wafer corresponding to the three-dimensional tier-number address.

The wafer to wafer stacking structure is tested by using the test method in this embodiment of this application. In the wafer to wafer stacking structure, the logic wafer and the plurality of tiers of memory wafers are connected through the bus. The bus records a tier address of each memory wafer in the wafer to wafer stacking structure. The logic wafer includes the tier address port for transmitting the tier address to the plurality of tiers of memory wafers. The to-be-tested three-dimensional tier-number address is obtained, and the addresser reads, through the tier address port of the logic wafer and the bus, the tier address of each of the plurality of tiers of memory wafers corresponding to the to-be-tested three-dimensional tier-number address, so that the addresser can read probe information including quality of a cut unit on a memory wafer corresponding to the tier address, and the read probe information can be used in combination with a production process to adjust a connection status of the cut unit in the wafer to wafer stacking structure, where the adjustment includes performing corresponding repair or shielding on a defective product. In this way, a tier at which a corresponding memory chip indicated as a defective product is located is addressed and shielded for a high bandwidth memory obtained by cutting the wafer to wafer stacking structure. Therefore, data is no longer accessed by the shielded memory chip when the high bandwidth memory is used, an actual available memory capacity in the high bandwidth memory is adjusted, and a plurality of types of high bandwidth memories with a part of capacity reduced are provided. In this way, a production yield rate of the high bandwidth memory is improved, and production costs of the high bandwidth memory are reduced.

In a first possible implementation of the first aspect, after the reading, by the addresser based on the three-dimensional tier-number address through the tier address port of the logic wafer and the bus, probe information of a memory wafer having a tier address corresponding to the three-dimensional tier-number address, the method further includes: outputting repair indication information based on the probe information, where the repair indication information is used to indicate information about a repairable location in the cut unit. Corresponding repair indication information is output based on the probe information, so that the repairable location in the cut unit can be indicated, to support repair of the wafer to wafer stacking structure after a test. Therefore, the production yield rate of the wafer to wafer stacking structure is improved.

In a second possible implementation of the first aspect, the probe information includes an identifier of the cut unit, a quantity of failure memory units in a memory area of each cut unit, and location information of the failure memory unit, where the identifier of the cut unit is used to indicate a two-dimensional row address and a two-dimensional column address of the cut unit. The quantity and locations of failure memory units in the memory area of the cut unit are obtained by using the probe information. The two-dimensional row address and the two-dimensional column address can accurately indicate a location of the cut unit on a memory wafer in which the cut unit is located, so that accurate repair indication information is provided.

In a third possible implementation of the first aspect, the probe information further includes a quantity of redundancy memory units in each cut unit; and the outputting repair indication information based on the probe information includes: determining, based on the quantity of failure memory units in the memory area of each cut unit and the quantity of redundancy memory units in each cut unit, whether the cut unit is repairable; and when the cut unit is repairable, outputting the repair indication information. Whether each cut unit is repairable is determined based on the obtained quantity of failure memory units in the memory area and the obtained quantity of redundancy memory units. When it is determined that the cut unit is repairable, the repair indication information is output to support repair in subsequent wafer to wafer stacking structure production.

In a fourth possible implementation of the first aspect, the outputting repair indication information includes: when the cut unit is repairable, determining location information of a repairable memory unit in the repairable cut unit; and outputting the location information of the repairable memory unit in the repairable cut unit. In this way, in a repair process of producing the wafer to wafer stacking structure, the location information of the repairable memory unit in the repairable cut unit can be obtained based on the repair indication information for repair. Therefore, the production yield rate of the wafer to wafer stacking structure is improved by repairing the repairable memory unit.

In a fifth possible implementation of the first aspect, after the determining, based on the quantity of failure memory units in the memory area of each cut unit and the quantity of redundancy memory units in each cut unit, whether the cut unit is repairable, the method further includes: when the cut unit is irreparable, determining that the cut unit is a defective product, and outputting an identifier of the defective product. For the cut unit that is determined to be irreparable, the identifier of the defective product is output, so that the corresponding cut unit that is a defective product cut unit can be shielded based on the identifier of the defective product in a production process of the wafer to wafer stacking structure. Therefore, a high bandwidth memory whose memory capacity can be flexibly adjusted based on a specific production result is obtained.

According to a second aspect of embodiments of this application, a production method for a high bandwidth memory is provided. The high bandwidth memory is obtained by cutting a wafer to wafer stacking structure. The wafer to wafer stacking structure includes a logic wafer and a plurality of tiers of memory wafers, where the logic wafer and the plurality of tiers of memory wafers are stacked in sequence. The logic wafer and the plurality of tiers of memory wafers are connected through a bus. The logic wafer includes a tier address port for transmitting a tier address to the plurality of tiers of memory wafers through the bus. The production method includes: obtaining probe information output by a test machine, where the probe information is used to indicate quality of a cut unit on a memory wafer detected based on a three-dimensional tier-number address and a corresponding tier address; adjusting a connection status of the cut unit in the wafer to wafer stacking structure based on the probe information, where the connection status includes a signal connection relationship between the cut unit and another cut unit located at an adjacent tier; and cutting an adjusted wafer to wafer stacking structure to obtain the high bandwidth memory, where the high bandwidth memory includes a cut unit of the logic wafer and a cut unit of each stacked memory wafer. The cut unit of the logic wafer and the cut units of the plurality of tiers of memory wafers are connected through the bus. The cut unit of the logic wafer includes a tier address port for transmitting a tier address to the cut units of the plurality of tiers of memory wafers through the bus. The cut unit of the logic wafer serves as a logic chip, and the cut unit of the memory wafer serves as a memory chip.

The bus records a tier address of each memory wafer, so that the logic wafer can address the plurality of tiers of memory wafers through the tier address port and the bus, and transmit data through the bus. When the probe information includes a tier address of a cut unit indicated as a defective product, the wafer to wafer stacking structure can be adjusted by adjusting a signal connection relationship between the cut unit and another cut unit located at an adjacent tier, so that a memory chip indicated as a defective product can be shielded for the high bandwidth memory obtained through cutting. Therefore, a high bandwidth memory whose memory capacity can be flexibly adjusted based on a specific production result is obtained.

In a first possible implementation of the second aspect, the probe information includes an identifier of the cut unit, a quantity of failure memory units in a memory area of each cut unit, and location information of the failure memory unit, where the identifier of the cut unit is used to indicate a two-dimensional row address and a two-dimensional column address of the cut unit. By using the two-dimensional row address and the two-dimensional column address of the cut unit as an indication of the identifier of the cut unit, a location of a to-be-repaired cut unit on a memory wafer can be accurately learned. In this way, a circuit originally connected to the failure memory unit can be bypassed, and then the repairable memory unit is connected to a corresponding redundancy memory unit based on the probe information. In other words, the failure memory unit is replaced with the redundancy memory unit.

In a second possible implementation of the second aspect, the probe information further includes a quantity of redundancy memory units in each cut unit; and before the cutting an adjusted wafer to wafer stacking structure to obtain the high bandwidth memory, the method further includes: determining location information of a repairable memory unit in a repairable cut unit based on the quantity of failure memory units in the memory area of each cut unit and the quantity of redundancy memory units in each cut unit; locating the repairable memory unit based on the location information of the repairable memory unit, bypassing a circuit of the repairable memory unit, and correspondingly connecting the repairable memory unit to the redundancy memory unit. In this way, before cutting and subsequent packaging processing are performed on the wafer to wafer stacking structure to obtain the high bandwidth memory, the repairable cut unit is first repaired, and a cut unit that still fails after repair or cannot be repaired is shielded. Whether a cut unit is repairable is determined based on whether a quantity of redundancy memory units in a redundancy area can meet a corresponding quantity of failure memory units that are to be replaced. A repairable cut unit can be located based on location information and repaired by replacing the circuit.

In a third possible implementation of the second aspect, the adjusting a connection status of the cut unit in the wafer to wafer stacking structure based on the probe information includes: shielding a cut unit indicated as a defective product in the probe information. A shielding operation is performed on the cut unit indicated as a defective product, and address information of the shielded cut unit is recorded and marked. When a wafer is used as the high bandwidth memory after the cut unit is cut, a memory chip corresponding to the marked address is shielded during data transmission, the memory chip is no longer used for data access, and a memory chip at another tier may normally perform data access.

According to a third aspect of embodiments of this application, a wafer to wafer stacking structure is provided. The wafer to wafer stacking structure includes a logic wafer and a plurality of tiers of memory wafers, where the logic wafer and the plurality of tiers of memory wafers are stacked in sequence. The logic wafer and the plurality of tiers of memory wafers are connected through a bus, and the logic wafer includes a tier address port.

The tier address port is configured to connect to an address bus in the bus, and transmit tier addresses of the plurality of tiers of memory wafers. When a test result of a test machine indicates that a cut unit in a specific tier of memory wafer is a defective product, a tier of a memory wafer in which the cut unit indicated as the defective product is located may be accurately addressed based on a tier address, so that the cut unit indicated as the defective product can be marked in a shielding manner, and data is no longer accessed by the cut unit. Therefore, the wafer to wafer stacking structure including the defective product is still available after being shielded, and a production yield rate of a high bandwidth memory formed after the wafer to wafer stacking structure is cut is improved.

In a first possible implementation of the third aspect, the bus records a tier address of each memory wafer, and the tier address port on the logic wafer is used to transmit the tier address of each memory wafer. According to the wafer to wafer stacking structure in this embodiment of this application, a memory wafer at each tier can be accurately addressed, and a location of a corresponding memory wafer for data access can be determined.

In a second possible implementation of the third aspect, the logic wafer and the plurality of tiers of memory wafers are interconnected through a through silicon via or a hybrid bonding bus. Both a through silicon via manner and a hybrid bonding manner have good connection reliability and low process costs. In addition, heat dissipation is good, and a structure of a produced high bandwidth memory is compact. This facilitates miniaturization of a structure of a device using the high bandwidth memory.

According to a fourth aspect of embodiments of this application, a high bandwidth memory is provided, including a logic chip and a plurality of tiers of memory chips, where the logic chip and the plurality of tiers of memory chips are stacked in sequence. The logic chip and the plurality of tiers of memory chips are connected through a bus, the bus records a tier address of each memory chip, and the logic chip includes a tier address port for transmitting a tier address to the plurality of tiers of memory chips through the bus.

The tier address port is configured to connect to an address bus in the bus, and transmit tier addresses of the plurality of tiers of memory wafers. Therefore, by using a connection status adjustment manner such as shielding or repairing after addressing, a high bandwidth memory whose memory capacity can be flexibly adjusted based on a specific production result and that is obtained through cutting can be obtained, so that a production yield rate of the high bandwidth memory formed through cutting is improved.

In a first possible implementation of the fourth aspect, the plurality of tiers of memory chips include at least one tier of shielded memory chip. An actual available memory capacity in the high bandwidth memory obtained through cutting is adjusted based on the test result of the test machine by addressing, shielding, or repairing a cut unit in the wafer to wafer stacking structure after the test, so that a plurality of types of high bandwidth memories with a part of capacity reduced can be provided. Therefore, production efficiency and a production yield rate of the high bandwidth memory are improved, and production costs of the high bandwidth memory are reduced.

### BRIEF DESCRIPTION OF DRAWINGS

FIG. 1 is a first schematic diagram of a structure of a wafer to wafer stacking structure according to an embodiment of this application;
FIG. 2 is a schematic diagram of testing of a wafer to wafer stacking structure by using an addresser of a test machine according to an embodiment of this application;
FIG. 3 is a first flowchart of a test method for a wafer to wafer stacking structure according to an embodiment of this application;
FIG. 4 is a test logical relationship diagram of a test method for a wafer to wafer stacking structure according to an embodiment of this application;
FIG. 5 is a second flowchart of a test method for a wafer to wafer stacking structure according to an embodiment of this application;
FIG. 6 is a third flowchart of a test method for a wafer to wafer stacking structure according to an embodiment of this application;
FIG. 7 is a fourth flowchart of a test method for a wafer to wafer stacking structure according to an embodiment of this application;
FIG. 8 is a fifth flowchart of a test method for a wafer to wafer stacking structure according to an embodiment of this application;
FIG. 9 is a second schematic diagram of a structure of a wafer to wafer stacking structure according to an embodiment of this application;
FIG. 10 is a first flowchart of a production method for a high bandwidth memory according to an embodiment of this application;
FIG. 11 is a schematic diagram of a forming relationship of a high bandwidth memory obtained by cutting a wafer to wafer stacking structure according to an embodiment of this application;
FIG. 12 is a second flowchart of a production method for a high bandwidth memory according to an embodiment of this application;
FIG. 13 is a third flowchart of a production method for a high bandwidth memory according to an embodiment of this application; and
FIG. 14 is a schematic diagram of a structure of a high bandwidth memory according to an embodiment of this application.

Reference numerals: 10: logic wafer; 101: cut unit of a logic wafer; 11: logic chip; 20: memory wafer; 201: cut unit of a memory wafer; 21: memory chip; 30: bus; and 40: addresser.

### DESCRIPTION OF EMBODIMENTS

To make the objectives, technical solutions, and advantages of embodiments of this application clearer, the following clearly and completely describes the technical solutions in embodiments of this application with reference to the accompanying drawings in embodiments of this application. It is clear that, the described embodiments are merely a part rather than all of embodiments of this application. Components in embodiments of this application that are generally described and illustrated in the accompanying drawings herein may be arranged and designed in various different configurations.

Therefore, the following detailed descriptions of embodiments of this application provided in the accompanying drawings are not intended to limit the scope of this application, but merely represent selected embodiments of this application. All other embodiments obtained by a person of ordinary skill in the art based on embodiments of this application without creative efforts shall fall within the protection scope of this application.

It should be noted that similar reference numerals and letters represent similar items in the following accompanying drawings. Therefore, once an item is defined in one accompanying drawing, it does not need to be further defined and explained in the following accompanying drawings.

In the descriptions of embodiments of this application, it should be noted that, if directions or location relationships indicated by the terms "up", "down", "left", "right", and the like are based on directions or location relationships shown in the accompanying drawings, or directions or location n relationships in which products in this application are commonly placed when the products are used, the directions or the location relationships are merely intend to conveniently describe this application and simplify the description, but are not intended to indicate or imply that an apparatus or element needs to have a particular direction and needs to be constructed and operated in the particular direction. Therefore, such terms cannot be understood as a limitation on this application. In addition, the terms "first", "second", and the like are merely used for distinction and description, and cannot be understood as an indication or implication of relative importance.

In the descriptions of embodiments of this application, it should be further noted that, unless otherwise specified and limited, the terms "setting", "installation", "interconnection", and "connection" should be understood in a broad sense. For example, the terms may indicate a fixed connection, a detachable connection, or an integrated connection; may be a mechanical connection or an electrical connection; or may be direct connection, indirect connection through an intermediate medium, or communication between the interior of two elements. For a person of ordinary skill in the art, a specific meaning of the foregoing terms in this application may be understood according to a specific situation.

There are generally two stacking manners for producing a high bandwidth memory: a die to die (D2D, die to die stacking) manner and a wafer to wafer (W2W, wafer to wafer stacking) manner.

The die to die manner means that each die (a chip structure before cutting and packaging, Die) is tested and screened. Each to-be-stacked cut unit is first tested and screened, and a KGD (Known Good Die, known good die) that passes a test is selected for stacking. In this way, a high production yield rate of a produced high bandwidth memory can be implemented. However, because KGDs are tested and screened one by one, production efficiency of the high bandwidth memory in the die to die manner is low. In addition, in a die to die production process, a volume of a micro solder bump (Micro-Bump) is miniaturized and compactness between adjacent micro solder bumps is limited, and a size of a minimum physical repetition unit of interconnected micro solder bumps (Micro-Bump) is large and is usually about 40 µm. Consequently, improvement of interconnection density on a chip is limited, and the produced high bandwidth memory has a large overall volume. Moreover, because underfill (bottom filling) needs to be used for interconnection in the die to die production process, a component has a high thermal conductivity, and cannot meet a high-power heat dissipation requirement.

The wafer to wafer stacking manner is stacking an entire tier of wafer by using a wafer tier as a unit. This can effectively improve production efficiency. In the wafer to wafer stacking manner, a yield rate test is generally performed after all tiers of wafers are stacked. In the conventional technology, a yield rate of a wafer at each single tier can generally reach about 90%. After a plurality of tiers of wafers are stacked, a yield rate of the wafer needs to meet a formula: p = αnβn-1, where α is a yield rate of a wafer, β is a yield rate of stacked wafers, and n is a quantity of stacked tiers. It can be learned from the formula that as the quantity of stacked wafer tiers increases, a yield rate of a finished high bandwidth memory product geometrically decreases. In a wafer to wafer stacking structure produced in the wafer to wafer stacking manner, a logic wafer cannot learn a tier at which each tier of memory wafer stacked on the logic wafer is located. Therefore, for a high bandwidth memory obtained through cutting, if a memory chip at any tier on a logic chip is detected as a defective product, the entire high bandwidth memory cannot be used and can only be discarded as the defective product. As a result, production costs of a good high bandwidth memory produced in the wafer to wafer stacking manner are greatly increased.

An embodiment of this application provides a test method for a wafer to wafer stacking structure, and the method may be applied to a test machine. The test machine is configured to test the wafer to wafer stacking structure. Generally, a test performed on the wafer to wafer stacking structure by using the test machine includes a direct current test and a function test. The test machine usually includes a tester (Tester) and a prober (prober). The tester is a controller, and is configured to execute a test program. The prober is connected to a to-be-tested wafer by using an addresser to implement a signal connection with each test point (a cut unit) in the to-be-tested wafer.

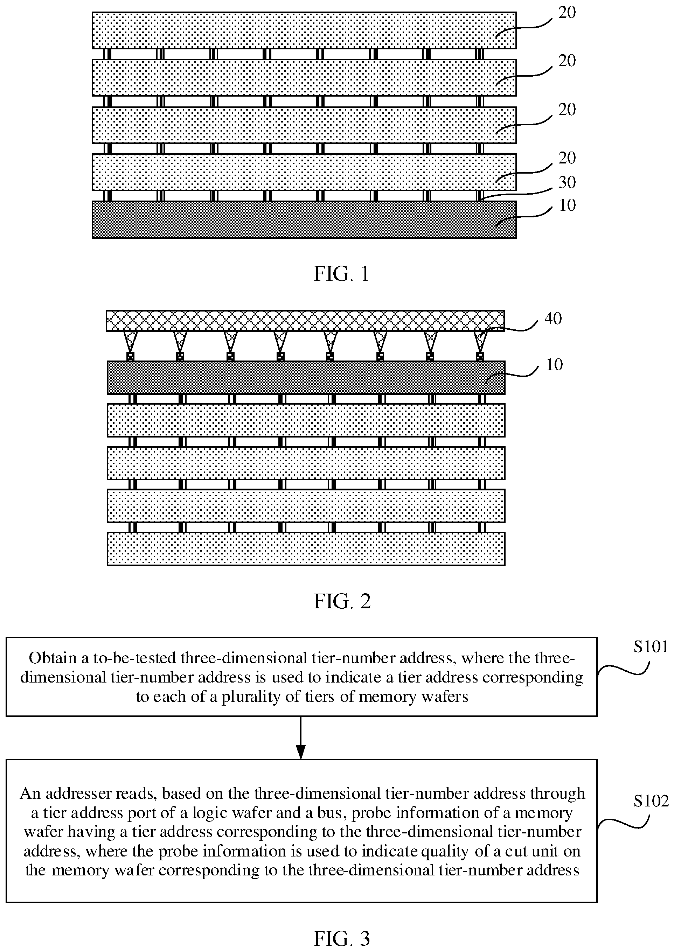

FIG. 1 is a first schematic diagram of a structure of a wafer to wafer stacking structure according to an embodiment of this application. As shown in FIG. 1, the wafer to wafer stacking structure includes a logic wafer 10 and a plurality of tiers of memory wafers 20, where the logic wafer 10 and the plurality of tiers of memory wafers 20 are stacked in sequence. The logic wafer 10 and the plurality of tiers of memory wafers 20 are connected through a bus 30 (four tiers of memory wafers 20 are used as an example in FIG. 1, which is the same in the following). The logic wafer 10 sends a control signal, and performs data transmission with the memory wafers 20 and stores data into the memory wafers 20 through the bus 30. FIG. 2 is a schematic diagram of testing of a wafer to wafer stacking structure by using an addresser of a test machine according to an embodiment of this application. As shown in FIG. 2, an addresser 40 of the test machine is configured to connect to a logic wafer 10. Corresponding to the wafer to wafer stacking structure in FIG. 1, the addresser 40 of the test machine is connected to a test port (pad) reserved on the logic wafer 10. The addresser 40 is connected to the logic wafer 10, to implement a connection to the plurality of tiers of memory wafers 20 stacked on the logic wafer 10. In an implementation, the test port reserved on the logic wafer 10 corresponds to a cut unit 101 on each logic wafer 10, and the cut unit 101 on each logic wafer 10 are correspondingly connected to cut units 201 of a plurality of tiers of memory wafers 20 stacked on the cut unit 101. The bus 30 records a tier address of each memory wafer 20. Therefore, the addresser 40 of the test machine is connected to the test port on the logic wafer 10, so that each tier of memory wafer 20 can be tested through addressing.

FIG. 3 is a flowchart of a test method for a wafer to wafer stacking structure according to an embodiment of this application. This method is performed by a test machine.

The test method for a wafer to wafer stacking structure provided in this embodiment of this application includes the following steps.

S101: Obtain a to-be-tested three-dimensional tier-number address, where the three-dimensional tier-number address is used to indicate a tier address corresponding to each of a plurality of tiers of memory wafers.

In the wafer to wafer stacking structure, the structure of the wafer to wafer stacking structure shown in FIG. 1 is used as an example. A tier address of each of the plurality of tiers of memory wafers 20 stacked on the logic wafer 10 are recorded on the bus 30. A corresponding port is disposed on the logic wafer 10 for corresponding signal transmission through the bus 30. A tier address port disposed on the logic wafer 10 is configured to transmit tier addresses of the plurality of tiers of memory wafers 20, the tier address is transmitted in an address bus of the bus 30 through the tier address port, and the tier address of each tier of memory wafer 20 is correspondingly recorded and read. The three-dimensional tier-number address is corresponding to the tier address of each of the plurality of tiers of memory wafers 20. The test machine obtains the to-be-tested three-dimensional tier-number address. In other words, the to-be-tested three-dimensional tier-number address can correspondingly indicate a tier address of a specific tier of memory wafer 20 in the plurality of tiers of memory wafers 20, so that a tier at which a wafer currently tested in the test machine is located in the wafer to wafer stacking structure can be determined.

The to-be-tested three-dimensional tier-number address may be written in a test program preset in the test machine. By connecting the addresser 40 of the test machine to the test port (pad) reserved on the logic wafer 10 and running the test program in the test machine, the plurality of tiers of memory wafers 20 may be tested separately by using the three-dimensional tier-number address added in the test program. Alternatively, the preset test program in the test machine may not be changed, but an external signal is used to indicate the to-be-tested three-dimensional tier-number address to the test machine, and the test machine detects a memory wafer 20 at a corresponding tier address based on the three-dimensional tier-number address of the external signal. A data source of the three-dimensional tier-number address is not limited in this embodiment of this application, as long as the to-be-tested three-dimensional tier-number address can be obtained and the tier addresses of the plurality of tiers of memory wafers 20 can be correspondingly addressed.

S102: The addresser reads, based on the three-dimensional tier-number address through the tier address port of the logic wafer and the bus, probe information of a memory wafer having a tier address corresponding to the three-dimensional tier-number address, where the probe information is used to indicate quality of a cut unit on the memory wafer corresponding to the three-dimensional tier-number address.

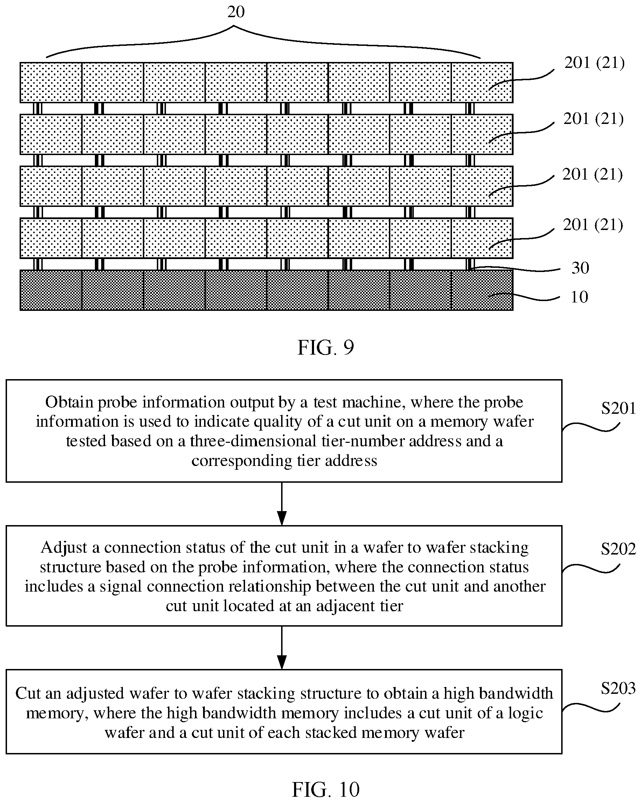

FIG. 9 is a second schematic diagram of a structure of a wafer to wafer stacking structure according to an embodiment of this application. As shown in FIG. 9, a memory wafer 20 at each tier includes a plurality of cut units 201, configured to serve as memory chips 21 at the tier in each high bandwidth memory obtained through cutting. Each cut unit 201 has a unique and definite physical location on the memory wafer 20. Cut units 201 on a plurality of tiers of memory wafers 20 are stacked and electrically connected in a tier direction. The stacked cut units 201 form a stacking structure of a high bandwidth memory after subsequent cutting and packaging steps. The test machine determines, by using the tier address corresponding to the three-dimensional tier-number address, a tier at which a currently to-be-tested memory wafer 20 is located, and correspondingly reads probe information of the memory wafer 20 at the tier, where the probe information includes quality of each cut unit 201 on the memory wafer 20.

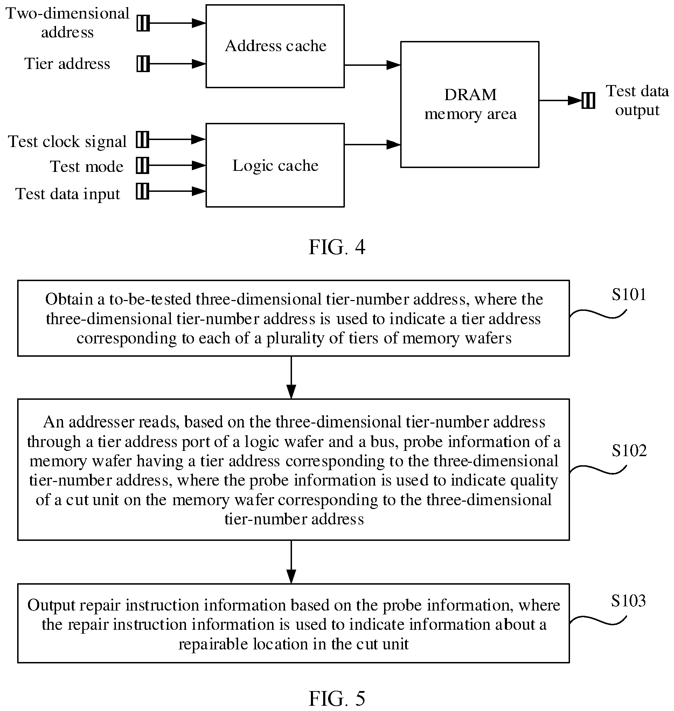

A logic wafer 10 and the plurality of tiers of memory wafers 20 are connected through a bus 30, and the bus 30 records and transmits information about the memory wafers 20. In an implementation, the bus 30 may include an address bus, a data bus, and a control bus. Corresponding ports are separately disposed on the logic wafer 10. The logic wafer 10 includes a tier address port. The tier address port may transmit a tier address to the plurality of tiers of memory wafers 20 through the bus 30. The logic wafer 10 is connected to the address bus in the bus 30 through the tier address port, and transmits the tier address to the plurality of tiers of memory wafers 20 connected to the bus 30. For example, FIG. 4 is a test logical relationship diagram of a test method for a wafer to wafer stacking structure according to an embodiment of this application. As shown in FIG. 4, an address bus includes a tier address port (HI. Add) for transmitting a tier address of each memory wafer 20, and a two-dimensional address port for transmitting a two-dimensional address of each cut unit 201 on the memory wafer 20. A data bus includes a test data input port (TDI) for transmitting test data information, a corresponding port for test mode selection (TMS), and a corresponding port for receiving a test clock (TCK) signal.

For a test of the wafer to wafer stacking structure, a test machine obtains a to-be-tested three-dimensional tier-number address, where the to-be-tested three-dimensional tier-number address is corresponding to a tier address of a specific to-be-tested memory wafer 20 in the wafer to wafer stacking structure. The test machine tests each cut unit 201 on the tier of memory wafer 20 based on a compiled test program and a test item. The test machine separately inputs corresponding address information and data information through ports, the address information and the data information are accessed the cut unit 201 on the memory wafer 20 after being converted by a circuit in a logic wafer 10, and receives detected probe information after the probe information is processed by the circuit in the logic wafer 10.

In an implementation, after the tier of memory wafer 20 is tested, the foregoing steps may be repeated. Another memory wafer 20 corresponding to a tier-number address is determined based on a different three-dimensional tier-number address, and then each cut unit 201 on the memory wafer 20 is tested, until a tier-by-tier test for a plurality of tiers of stacked memory wafers 20 is completed.

A test for a specific tier of memory wafer 20 is used as an example. A physical location of each cut unit 201 on the memory wafer 20 is indicated by using a two-dimensional row address and a two-dimensional column address. Based on the clock signal (TCK), an addresser 40 sequentially accesses, reads, and records information about each cut unit 201 row by row or column by column, and uses the information as probe information of the tier of memory wafer 20. The probe information can indicate quality of each cut unit 201 on the tier of memory wafer 20 based on the information about each cut unit 201.

By using the foregoing test method, after the test ends, the test machine can learn quality of each cut unit 201 on each tier of memory wafer 20 in the wafer to wafer stacking structure, and can determine a two-dimensional address of a memory wafer 20 on which each cut unit 201 is located and a tier address at which the memory wafer 20 is located. In this way, a cut unit 201 indicated as a defective product can be addressed and shielded based on a requirement. The shielded cut unit 201 does not access data when a subsequently formed high bandwidth memory is used, and a cut unit 201 indicated as a good product at another tier can normally access data in the formed high bandwidth memory. In other words, that a cut unit 201 indicated as a good product is addressed and shielded is equivalent that a quantity of tiers is reduced and a capacity of a corresponding tier is reduced, so that a memory that originally cannot be used can be optimized. Therefore, a production yield rate of the wafer to wafer stacking structure is improved, and production costs of the high bandwidth memory are reduced.

In an implementation, the probe information directly indicates quality of the cut unit 201. A connection status and a data accessibility status of each memory unit in the cut unit 201 are obtained based on the probe information, availability of each memory unit is determined, and it is determined, based on the availability of the memory unit in the cut unit 201, whether the cut unit 201 is a good product or a defective product. For example, if all memory units in the cut unit 201 are valid, or a quantity of memory units that are determined as failure memory units in the cut unit 201 through test is recorded and is compared with a preset quantity of redundancy memory units in the cut unit 201, and if the quantity of failure memory units is less than the preset quantity of redundancy memory units, the failure memory unit may be repaired through circuit replacement, and probe information may be used to indicate that the cut unit 201 is a good product. On the contrary, the quantity of memory units that are determined as failure memory units in the cut unit 201 through test is recorded and is compared with the preset quantity of redundancy memory units in the cut unit 201, and if the quantity of failure memory units is greater than the preset quantity of redundancy memory units, probe information may be used to indicate that the cut unit 201 is a defective product. Quality of the cut unit 201 on a specific tier of memory wafer 20 is directly indicated by the probe information, and the quality of the cut unit 201 is provided as a basis for adjusting a signal connection relationship between the cut unit 201 and another cut unit 201 at an adjacent tier in a corresponding step in a subsequent production method.

It should be noted that, in this embodiment of this application, an information representation form of the probe information is not limited. A specific information representation form may be set based on a test program compiled in the test machine. In an implementation, the probe information may directly or indirectly indicate the quality of the cut unit 201. Alternatively, in another implementation, the probe information may not indicate the quality, and another device or terminal performs determining after parsing the probe information, as long as the probe information can include a tier address of the memory wafer 20 corresponding to the three-dimensional tier-number address, and corresponding information that can indicate the quality of the cut unit 201 in the tier of memory wafer 20. Embodiments of this application provide a wafer to wafer stacking structure and a test method therefor, and a high bandwidth memory and a production method therefor. The test method for a wafer to wafer stacking structure is applied to a test machine, and the test machine is configured to test the wafer to wafer stacking structure. The wafer to wafer stacking structure includes a logic wafer and a plurality of tiers of memory wafers, where the logic wafer and the plurality of tiers of memory wafers are stacked in sequence. The logic wafer and the plurality of tiers of memory wafers are connected through a bus. The logic wafer includes a tier address port for transmitting a tier address to the plurality of tiers of memory wafers through the bus. An addresser of the test machine is configured to connect to the logic wafer. The method includes: obtaining a to-be-tested three-dimensional tier-number address, where the three-dimensional tier-number address is used to indicate a tier address corresponding to each of the plurality of tiers of memory wafers; and reading, by the addresser based on the three-dimensional tier-number address through the tier address port of the logic wafer and the bus, probe information of a memory wafer corresponding to the three-dimensional tier-number address, where the probe information is used to indicate quality of a cut unit on the memory wafer corresponding to the three-dimensional tier-number address. The wafer to wafer stacking structure is tested by using the test method in embodiments of this application. In the wafer to wafer stacking structure, the logic wafer is connected to the plurality of tiers of memory wafers through the tier address port and the bus. The bus records a tier address of each memory wafer in the wafer to wafer stacking structure. The to-be-tested three-dimensional tier-number address is obtained, and the addresser reads a tier address corresponding to the to-be-tested three-dimensional tier-number address, so that the addresser can read probe information including quality of a cut unit on a memory wafer corresponding to the tier address, and the read probe information can be used in combination with a production process to adjust a connection status of the cut unit in the wafer to wafer stacking structure, where the adjustment includes performing corresponding repair or shielding on a defective product. In this way, a tier at which a corresponding memory chip indicated as a defective product is located is addressed and shielded for a high bandwidth memory obtained by cutting the wafer to wafer stacking structure. Therefore, data is no longer accessed by the shielded memory chip when the high bandwidth memory is used, an actual available memory capacity in the high bandwidth memory is adjusted, and a plurality of high bandwidth memories with a part of capacity reduced are provided. In this way, a production yield rate of the high bandwidth memory is improved, and production costs of the high bandwidth memory are reduced.

Optionally, in a case in which a row address and a column address are jointly used to indicate the two-dimensional address of the cut unit 201 on the memory wafer 20 on which the cut unit 201 is located, and a corresponding repair operation can be performed on the tested wafer to wafer stacking structure based on an actual requirement after a test, the probe information includes an identifier of the cut unit 201, a quantity of failure memory units in a memory area of each cut unit 201, and location information of the failure memory unit, where the identifier of the cut unit 201 is used to indicate a two-dimensional row address and a two-dimensional column address of the cut unit 201.

FIG. 5 is a second flowchart of a test method for a wafer to wafer stacking structure according to an embodiment of this application. After step S102 in which the addresser reads, based on the three-dimensional tier-number address through the tier address port of the logic wafer and the bus, probe information of a memory wafer having a tier address corresponding to the three-dimensional tier-number address, as shown in FIG. 5, the test method in this embodiment of this application further includes the following step.

S103: Output repair indication information based on the probe information, where the repair indication information is used to indicate information about a repairable location in the cut unit.

For each cut unit 201 on the memory wafer 20, in an implementation, during design, each cut unit 201 is divided into a memory area and a redundancy area that are isolated from each other. The memory area includes a plurality of memory units, and the redundancy area includes a plurality of redundancy (Redundancy) memory units. It should be understood that a sum of capacities of the plurality of memory units in the memory area is an available memory capacity of the cut unit 201. However, the redundancy memory unit in the redundancy area is produced as a backup, and does not necessarily perform a data access function in actual use of the cut unit 201 after the cut unit 201 is cut. This needs to be determined based on a specific cabling connection.

In a production process of the cut unit 201, it cannot be ensured that the plurality of memory units in the memory area can always be valid and available in the production process and an interconnection process. Quality of the wafer, an error in production, and impact of an external factor may all cause a failure of some memory units in the memory area. Therefore, the redundancy memory units in the redundancy area are preset during design. In an implementation, a ratio of a quantity of redundancy memory units to a quantity of memory units on the cut unit 201 is set to about 1:10. In this way, if some memory units in the memory area fail in the production process, for example, some memory units are determined as failure units during an electrical test, there is still a chance to perform repair (Repair) through replacement by using the redundancy memory unit in the redundancy area.

The probe information includes an identifier of the cut unit 201, and the identifier is used to indicate the two-dimensional row address and the two-dimensional column address of the cut unit 201. A physical location of each cut unit 201 on the memory wafer 20 is determined based on the identifier of the cut unit 201. Because the physical location of each cut unit 201 cannot be changed after the memory wafers 20 are stacked, the identifier of the cut unit 201 can clearly indicate the cut unit 201 at each physical location on the memory wafer 20. In addition, the probe information further includes a quantity of failure memory units in the memory area of each cut unit 201 and location information of all failure memory units. When the failure memory units in the cut unit 201 are repaired, a location of each failure memory unit in the cut unit 201 can be correspondingly found based on the quantity of failure memory units and the location information of all the failure memory units. In this way, the repair indication information can be output based on the probe information, to indicate the information about the repairable location in the cut unit 201. By using the repair indication information that includes the information about the repairable location, a to-be-repaired cut unit 201 can be addressed and repaired.

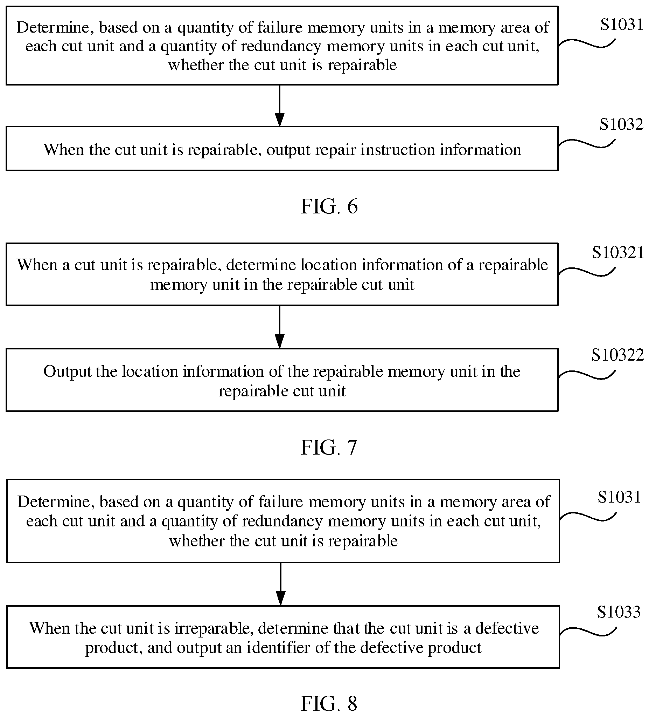

The redundancy area is preset when the cut unit 201 is designed, the redundancy memory unit is set in the redundancy area, and the redundancy memory unit has a same structure and function as the memory unit in the memory area. Therefore, when the cut unit 201 needs to be repaired, the memory unit may be replaced with the redundancy memory unit in a one-to-one manner by adjusting a circuit connection. Optionally, the probe information further includes a quantity of redundancy memory units in each cut unit 201. FIG. 6 is a third flowchart of a test method for a wafer to wafer stacking structure according to an embodiment of this application. In the test method in this application, as shown in FIG. 6, step S103 of outputting repair indication information based on the probe information includes the following steps.

S1031: Determine, based on the quantity of failure memory units in the memory area of each cut unit and the quantity of redundancy memory units in each cut unit, whether the cut unit is repairable.

S1032: When the cut unit is repairable, output the repair indication information.

In the cut unit 201, the quantity of failure memory units in the memory area obtained through test is unpredictable. If the quantity of preset redundancy memory units in the redundancy area is too large, a large quantity of redundancy memory units are idle. This increases production costs and affects size miniaturization of the produced high bandwidth memory. If the quantity of preset redundancy memory units in the redundancy area is too small, repairability is reduced, and a production yield rate of the high bandwidth memory is affected.

In an implementation, redundancy memory units preset in the redundancy area are generally divided and set based on a ratio of about 1:10 to a set quantity of memory units. If some memory units in the memory area have an error in the production process, and are determined to be failed during an electrical test, the redundancy memory unit in the redundancy area may be used for replacement to perform repair (Repair). For example, if the memory area includes 1000 memory units, 100 redundancy memory units are set in the redundancy area. The electrical test is performed on the cut unit 201 by using the addresser 40. If it is tested that some memory units in the memory area fail, and the quantity of failure memory units is less than the quantity of redundancy memory units, it may be determined that the cut unit 201 is repairable.

When the cut unit 201 is repairable, the repair indication information is output.

FIG. 7 is a fourth flowchart of a test method for a wafer to wafer stacking structure according to an embodiment of this application. As shown in FIG. 7, step S1032 of outputting the repair indication information when the cut unit is repairable includes the following steps.

S10321: When the cut unit is repairable, determine location information of a repairable memory unit in the repairable cut unit.

S10322: Output the location information of the repairable memory unit in the repairable cut unit.

Based on a comparison between the quantity of failure memory units in the cut unit 201 and the quantity of redundancy memory units in the cut unit 201, if the quantity of failure memory units in the cut unit 201 is less than the quantity of redundancy memory units in the cut unit 201, the cut unit 201 is determined to be repairable, the location information of the repairable memory unit in the repairable cut unit 201 is determined, and the location information of the repairable memory unit in the repairable cut unit 201 is output. In this way, a corresponding failure memory unit can be addressed based on the repair indication information, a circuit connection of the failure memory unit can be modified, and the failure memory unit can be replaced with a redundancy memory unit to complete repair.

FIG. 8 is a fifth flowchart of a test method for a wafer to wafer stacking structure according to an embodiment of this application. After step S1031 of determining, based on the quantity of failure memory units in the memory area of each cut unit and the quantity of redundancy memory units in each cut unit, whether the cut unit is repairable, as shown in FIG. 8, the test method further includes the following step.

S1033: When the cut unit is irreparable, determine that the cut unit is a defective product, and output an identifier of the defective product.

In an implementation, the quantity of redundancy memory units in the redundancy area is set based on a conventional ratio or a ratio required by a design. Therefore, not all cut units 201 are repairable when it is tested that there is a failure memory unit in the memory unit. If the quantity of failure memory units in the cut unit 201 is greater than the quantity of redundancy memory units in the cut unit 201, the cut unit 201 is irreparable. Alternatively, in another implementation, after the repairable cut unit 201 is repaired, an electrical test further needs to be performed for check. If the cut unit 201 that is repairable and that is repaired through replacement by using the redundancy memory unit still fails to pass the electrical test, repair of the cut unit 201 fails. In other words, it may also be considered that the cut unit 201 is irreparable. For the irreparable cut unit 201, the cut unit 201 is marked as a defective product, and an identifier of the defective product is output. After the wafer to wafer stacking structure is cut, the cut unit 201 indicated as the defective product is abandoned for use. For example, in the foregoing manner, for a memory chip formed by the cut unit 201 corresponding to the identifier of the defective product in the high bandwidth memory structure formed through cutting, data may not be accessed by this tier of memory chip in a manner of shielding an address, and data access by other tiers of memory chips is not affected.

Another aspect of embodiments of this application provides a production method for a high bandwidth memory. The high bandwidth memory is obtained by cutting a wafer to wafer stacking structure. The method is performed by a production device. FIG. 9 is another schematic diagram of a structure of a wafer to wafer stacking structure according to an embodiment of this application. As shown in FIG. 9, the wafer to wafer stacking structure is cut along a location between two adjacent cut units 201 in FIG. 9, to obtain a plurality of high bandwidth memories. The wafer to wafer stacking structure includes a logic wafer 10 and a plurality of tiers of memory wafers 20, where the logic wafer 10 and the plurality of tiers of memory wafers 20 are stacked in sequence. The logic wafer 10 and the plurality of tiers of memory wafers 20 are connected through a bus 30, and the logic wafer 10 includes a tier address port for transmitting a tier address to the plurality of tiers of memory wafers 20 through the bus 30.

FIG. 10 is a first flowchart of a production method for a high bandwidth memory according to an embodiment of this application. As shown in FIG. 10, the production method for a high bandwidth memory in this embodiment of this application includes the following steps.

S201: Obtain probe information output by a test machine, where the probe information is used to indicate quality of a cut unit on a memory wafer tested based on a three-dimensional tier-number address and a corresponding tier address.

S202: Adjust a connection status of the cut unit in the wafer to wafer stacking structure based on the probe information, where the connection status includes a connection relationship between the cut unit and another cut unit located at an adjacent tier.

S203: Cut an adjusted wafer to wafer stacking structure to obtain the high bandwidth memory, where the high bandwidth memory includes a cut unit of a logic wafer and a cut unit of each stacked memory wafer. The cut unit of the logic wafer and cut units of the plurality of tiers of memory wafers are connected through the bus, the cut unit of the logic wafer includes a tier address port for transmitting a tier address to the cut units of the plurality of tiers of memory wafers through the bus, the cut unit of the logic wafer serves as a logic chip, and the cut unit of the memory wafer serves as a memory chip.

A person skilled in the art should learn that, before testing and repairing, a production process of the wafer to wafer stacking structure definitely further includes production process steps such as stacking and interconnection of the logic wafer 10 and the plurality of tiers of memory wafers 20. These production processes are not specifically limited in this embodiment of this application. For example, it is not limited that the plurality of tiers of memory wafers 20 are first sequentially stacked and then stacked with the logic wafer 10. Alternatively, the logic wafer 10 is first disposed, and then the plurality of tiers of memory wafers are stacked on the logic wafer 10 in sequence. In an implementation, a production device and a production process that are commonly used in the art may be used the foregoing production process steps, provided that the wafer to wafer stacking structure includes the logic wafer 10 and the plurality of tiers of memory wafers 20, where the logic wafer 10 and the plurality of tiers of memory wafers 20 are stacked in sequence, and the logic wafer 10 and the plurality of tiers of memory wafers 20 are connected through the bus 30. The bus 30 records a tier address of each memory wafer 20, the logic wafer 10 includes a tier address port, and the tier address is transmitted between the logic wafer 10 and the plurality of tiers of memory wafers 20 through the bus 30, so that addressing and data transmission can be performed on the plurality of tiers of memory wafers 20.

After the wafer to wafer stacking structure with the foregoing structure is formed, the probe information output by the test machine is obtained, where the probe information output by the test machine is used to indicate the quality of the cut unit 201 on the memory wafer 20 detected based on the three-dimensional tier-number address and the corresponding tier address.

Based on indication of quality of each cut unit 201 on a memory wafer 20 at a determined tier by the probe information, in an implementation, if the probe information indicates that a cut unit 201 is a defective product, a connection status of the cut unit 201 indicated as the defective product in the wafer to wafer stacking structure may be adjusted in the production device, to obtain an adjusted wafer to wafer stacking structure. The connection status includes a signal connection relationship between the cut unit 201 and another cut unit 201 at an adjacent tier.

An adjustment manner for the connection status of the cut unit 201 indicated as the defective product in the wafer to wafer stacking structure includes: In an implementation, an address (including a two-dimensional row address, a two-dimensional column address, and a tier address for determining a cut unit 201 on a unique memory wafer 20 in the wafer to wafer stacking structure) of the cut unit 201 indicated as the defective product is marked on the cut unit 101 corresponding to the logic wafer 10, so that the cut unit 201 indicated as the defective product is shielded by performing an addressing operation through an address bus. In this way, the shielded cut unit 201 is no longer used to access data. The cut unit 201 indicated as the defective product may also be shielded in the production device. In this way, an adjusted wafer to wafer stacking structure is obtained.

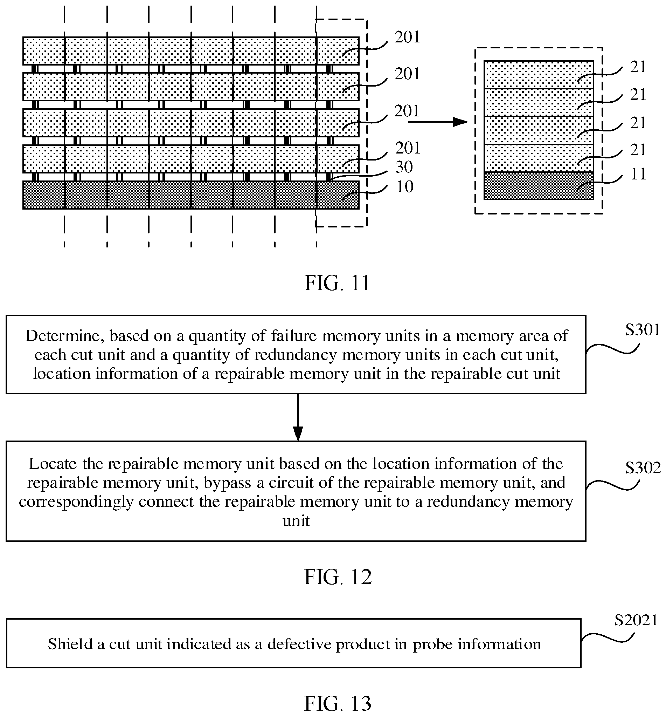

Then, the production device cuts the adjusted wafer to wafer stacking structure to obtain a high bandwidth memory. FIG. 11 is a schematic diagram of a forming relationship of a high bandwidth memory obtained by cutting a wafer to wafer stacking structure according to an embodiment of this application. As shown in FIG. 11, cutting is performed along a location shown by a dashed line in the wafer to wafer stacking structure in FIG. 11. After the cutting, a part in a dashed line box on the right of the arrow is a high bandwidth memory. The high bandwidth memory includes a cut unit 101 of a logic wafer 10 and a cut unit 201 of each stacked memory wafer 20. The cut unit 101 of the logic wafer 10 and cut units 201 of a plurality of tiers of memory wafers 20 are connected through a bus 30. The cut unit 101 of the logic wafer 10 includes a tier address port, and the cut unit 101 of the logic wafer 10 transmits a tier address to the cut units 201 of the plurality of tiers of memory wafers 20 through the tier address port. The cut unit 101 of the logic wafer 10 serves as a logic chip 11, and the cut unit 201 of the memory wafer 20 serves as a memory chip 21.

It should be noted that a person skilled in the art should learn that both the wafer to wafer stacking structure and the high bandwidth memory obtained through cutting shown in FIG. 11 are tier structures of a main direction view. Actually, in a top view plane of the wafer to wafer stacking structure, the memory wafer 20 should include cut units 201 that are in a plurality of rows and a plurality of columns that are arranged in a matrix form. FIG. 11 is only a schematic diagram of cutting along a row direction or a column direction. In an implementation, cutting is performed in both the row direction and the column direction in actual cutting, and a top view direction of the high bandwidth memory formed through cutting includes only an area range of a cut unit 101 of one logic wafer 10 or a cut unit 201 of one memory wafer 20.

Probe information obtained in a production method in this embodiment of this application is from a test machine. The probe information detected by the test machine includes an identifier of the cut unit 201, a quantity of failure memory units in a memory area of each cut unit 201, and location information of the failure memory unit, where the identifier of the cut unit 201 is used to indicate a two-dimensional row address and a two-dimensional column address of the cut unit 201.

In an implementation, during design, each cut unit 201 is divided into a memory area and a redundancy area that are isolated from each other, and a redundancy memory unit is set in the redundancy area. The redundancy memory unit has a same structure and function as a memory unit in the memory area. When some memory units in the memory area fail in a production process, the failure memory units may be replaced with redundancy memory units in the redundancy area. In an implementation, a specific manner may be bypassing a circuit originally connected to the failure memory unit, and a repairable memory unit is connected to a corresponding redundancy memory unit. In other words, the failure memory unit is replaced with the redundancy memory unit.

To implement the foregoing replacement to repair a cut unit 201 of the failure memory unit, a location of the to-be-repaired cut unit 201 on the memory wafer 20 needs to be learned first. In an implementation, information of the location may be learned based on a two-dimensional row address and a two-dimensional column address of the cut unit 201 (an identifier of the cut unit 201) indicated in the probe information. The identifier of the cut unit 201 is indicated by using the two-dimensional row address and the two-dimensional column address. In another implementation, the identifier of the cut unit 201 may alternatively be other information that can indicate a physical location that is uniquely determined and that is of the cut unit 201 on the memory wafer 20. After a location of a to-be-repaired cut unit 201 on the memory wafer 20 is determined, a quantity of to-be-repaired failure memory units in the memory area and a location of each failure memory unit also need to be known, to perform accurate addressing and repair during repair.

The redundancy area is preset when the cut unit 201 is designed, the redundancy memory unit set in the redundancy area has a same structure and function as the memory unit set in the memory area. Therefore, the memory unit may be replaced with the redundancy memory unit in a one-to-one manner by adjusting a circuit. Optionally, the probe information further includes a quantity of redundancy memory units in each cut unit 201.

FIG. 12 is a second flowchart of a production method for a high bandwidth memory according to an embodiment of this application. Before step S203 of cutting an adjusted wafer to wafer stacking structure to obtain the high bandwidth memory, as shown in FIG. 12, the production method in this application further includes the following steps.

S301: Determine, based on the quantity of failure memory units in the memory area of each cut unit and the quantity of redundancy memory units in each cut unit, location information of a repairable memory unit in a repairable cut unit.

S302: Locate the repairable memory unit based on the location information of the repairable memory unit, bypass a circuit of the repairable memory unit, and correspondingly connect the repairable memory unit to the redundancy memory unit.

In this embodiment of this application, before cutting and subsequent packaging processing are performed on the wafer to wafer stacking structure to obtain the high bandwidth memory, the repairable cut unit 201 is first repaired, and the cut unit 201 that still fails after repair or cannot be repaired is shielded.

In an implementation of this application, before the cut unit 201 is repaired, whether the cut unit 201 is repairable needs to be first determined. The probe information detected by the test machine further includes a quantity of redundancy memory units in the redundancy area. According to the foregoing description, repair of the failure memory unit in the cut unit 201 is mainly implemented by performing address replacement between the redundancy memory unit and the failure memory unit for replacement. Therefore, whether the cut unit is repairable depends on whether a quantity of redundancy memory units in the redundant area can meet a corresponding quantity of failure memory units that are to be replaced.

Therefore, first, in step S301, the quantity of failure memory units in the memory area of each cut unit is compared with the quantity of redundancy memory units in each cut unit to determine whether the failure memory units are repairable. For a same cut unit 201, if a quantity of redundancy memory units is greater than or equal to a quantity of failure memory units, it may indicate that the cut unit 201 is repairable, and the failure memory unit in the cut unit 201 is considered as a repairable memory unit. Location information of the repairable memory unit 201 is determined, to perform addressing and repair in a subsequent repair process.

Then, step S302 is performed. For each repairable cut unit, a repairable memory unit is located based on location information of the repairable memory unit, a circuit of the repairable memory unit is bypassed, and the repairable memory unit is correspondingly connected to a redundancy memory unit. An electrical test needs to be further performed on the redundancy memory unit used for replacement. After the electrical test is passed, it may be considered that the repairable memory unit is valid.

FIG. 13 is a third flowchart of a production method for a high bandwidth memory according to an embodiment of this application. As shown in FIG. 13, step S202 of adjusting a connection status of the cut unit in the wafer to wafer stacking structure based on the probe information includes the following step.

S2021: Shield a cut unit indicated as a defective product in the probe information.

If the probe information indicates that a cut unit 201 on a memory wafer 20 fails to pass a test and all failure memory units cannot be repaired by using redundancy units based on a comparison between a quantity of failure memory units on the cut unit 201 and a quantity of redundancy memory units on the cut unit 201, the cut unit 201 is irreparable, a location of the cut unit 201 is indicated, and the cut unit 201 is marked as a defective product.

For the cut unit 201 indicated as the defective product, step S2021 is performed to shield the defective cut unit, address information of the shielded cut unit 201 is recorded and marked, the shielded cut unit 201 is no longer used to access data, and when a chip is used as the high bandwidth memory after the cut unit 201 is cut, a memory chip 21 corresponding to the marked address is shielded during data transmission.

It should be noted that, in this embodiment of this application, a production device that performs the production method for a high bandwidth memory is not specifically limited. In some cases, the production device alternatively includes the entirety of a plurality of devices that separately perform different steps. In an implementation, a production process step of stacking and interconnection of the logic wafer 10 and the plurality of tiers of memory wafers 20 is first performed in a stacking production device, and then the repairable cut unit 201 is repaired in a repair device based on the probe information output by the test machine, and the connection status of the cut unit 201 indicated as a defective product is adjusted. Then, a cutting operation is performed on the wafer to wafer stacking structure by using a cutting device, to obtain a high bandwidth memory.

In another implementation, the production method for a high bandwidth memory in this embodiment of this application may be further applied to production of another 3DIC product in a wafer to wafer stacking manner. For example, the method may be applied to stacking of photosensitive devices in an image sensor on a mobile phone or another small mobile terminal, or stacking of other components.

According to still another aspect of embodiments of this application, a wafer to wafer stacking structure is provided. Still refer to FIG. 1. The wafer to wafer stacking structure includes the logic wafer 10 and the plurality of tiers of memory wafers 20, where the logic wafer 10 and the plurality of tiers of memory wafers 20 are stacked in sequence. The logic wafer 10 and the plurality of tiers of memory wafers 20 are connected through the bus 30, and the logic wafer 10 includes a tier address port. In the wafer to wafer stacking structure in this embodiment of this application, the logic wafer 10 includes the tier address port, configured to connect to an address bus in the bus 30, and transmit tier addresses of the plurality of tiers of memory wafers 10. In an implementation, when it indicates, based on a test result of a test machine, that a cut unit 201 in a specific tier of memory wafer 20 is a defective product, a tier of the memory wafer 20 in which the cut unit 201 indicated as the defective product is located may be accurately addressed based on a tier address through the tier address port that is on the logic wafer 10 and that is connected to the bus 30, and a two-dimensional address of the cut unit 201 on the memory wafer 20 is obtained. In this way, the cut unit 201 indicated as the defective product can be marked in a shielding manner, and data is no longer accessed by the cut unit 201, so that the wafer to wafer stacking structure including the defective product is still available after the defective product is shielded. Therefore, a production yield rate of a high bandwidth memory formed through cutting is improved.

The bus 30 records a tier address of each memory wafer 20, and the tier address port on the logic wafer 10 is used to transmit the tier address of each memory wafer.

The bus 30 records the tier address of each memory wafer 20, so that a tier in which the memory wafer 20 is located can be correspondingly addressed based on the recorded tier address. In an implementation, the logic wafer 10 includes a control center, and an address decoder is disposed on each tier of memory wafer 20. The logic wafer 10 is connected to each tier of memory wafer 20. The control center of the logic wafer 10 sends instructions, and an address decoder at a corresponding tier processes the instructions, to determine a tier corresponding to the tier address. The tier address of each memory wafer 20 is transmitted through the tier address port on the logic wafer 10. In this way, according to the wafer to wafer stacking structure in this embodiment of this application, each tier of memory wafer 20 can be accurately addressed, and a location of a memory wafer 20 corresponding to data access can be determined.

In an implementation, for a physical implementation of the bus 30 for connecting the logic wafer 10 and the plurality of tiers of memory wafers 20, the logic wafer 10 and the plurality of tiers of memory wafers 20 may be connected through a through silicon via or hybrid bonding.

A through silicon via (through silicon via, TSV for short) technology is a technical solution for implementing interconnection between chips by stacking chips in a three-dimensional integrated circuit. The through silicon via technology can effectively implement stacking and interconnection of 3D chips. In addition, chip tier interconnection implemented in this manner can implement high density of chips stacked in a tier direction, a short interconnection circuit between chips, a small outline size, and high connection reliability. As another technology for implementing tier interconnection between three-dimensional stacked wafers, a hybrid bonding (Hybrid Bonding, HB) technology can implement internal interconnection of thousands of chips during bonding of two wafers, and has high connection reliability and low costs. According to the wafer to wafer stacking structure in this embodiment of this application, a wafer to wafer stacking manner is used, and interconnection may be implemented through a through silicon via or hybrid bonding, to implement a bus connection between the logic wafer 10 and the plurality of tiers of memory wafers 20. Both a through silicon via manner and a hybrid bonding manner have good connection reliability and low process costs. In addition, heat dissipation is good, and a structure of a produced high bandwidth memory is compact. This facilitates miniaturization of a structure of a device using the high bandwidth memory.

Still another aspect of embodiments of this application provides a high bandwidth memory. The high bandwidth memory in embodiments of this application is obtained by cutting a wafer to wafer stacking structure. FIG. 11 is a schematic diagram of a forming relationship of a high bandwidth memory obtained by cutting a wafer to wafer stacking structure according to an embodiment of this application. As shown in a schematic diagram on the right side of an arrow in FIG. 11, a logic chip 11 and a plurality of tiers of memory chips 21 are included, where the logic chip 11 and the plurality of tiers of memory chips 21 are stacked in sequence. The logic chip 11 and the plurality of tiers of memory chips 21 are connected through a bus 30. The bus 30 records a tier address of each memory chip 21, and the logic chip 11 includes a tier address port for transmitting a tier address to the plurality of tiers of memory chips 21 through the bus 30.

FIG. 11 does not show a location of a bus 30 in a high bandwidth memory structure. It can be learned from a schematic diagram before cutting shown on the left side of the arrow in FIG. 11 that, each high bandwidth memory structure formed through cutting includes a logic chip 11 and a plurality of tiers of memory chips 21, and a bus for connecting the logic chip 11 and the plurality of tiers of memory chips 21. The bus includes a control center part disposed on the logic chip 11, and an address decoder disposed on each tier of memory chip 21, and further includes an electrical connection circuit for connecting the logic chip 11 and each tier of memory chip 21. When address information is marked and data is stored, the control center in the logic chip 11 sends instructions, and an address decoder on a memory chip 21 at a corresponding tier decodes the instructions, to determine the memory chip 21 at the corresponding tier and access data.

For the high bandwidth memory in this embodiment of this application, in an implementation, the plurality of tiers of memory chips 21 include at least one tier of shielded memory chip 21.

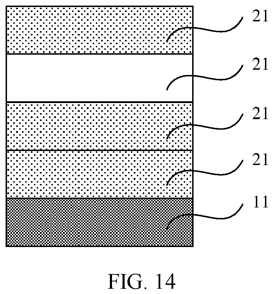

FIG. 14 is a schematic diagram of a structure of a high bandwidth memory according to an embodiment of this application. As shown in FIG. 14, that four tiers of memory chips 21 are stacked on a logic chip 11 and one tier of memory chip 21 is shielded is used as an example. The four tiers of memory wafers 20 are sequentially stacked on one tier of logic wafer 10 and the four tiers of memory wafers 20 and the one tier of logic wafer 10 are connected through a bus. Tier addresses of the four tiers of memory wafers 20 are recorded on the bus, and a two-dimensional address of each cut unit 201 in each tier of memory wafer 20 is further recorded on the bus. After the stacking is completed, an electrical test is performed, and a repairable cut unit 201 on the memory wafer 20 is repaired. One of high bandwidth memories formed by cutting the wafer to wafer stacking structure is shown in FIG. 14. In an implementation, the high bandwidth memory includes a logic chip 11 and four tiers of memory chips 21 that are stacked in sequence on the logic chip 11. A memory chip 21 at a third tier is marked as a defective product and shielded on the bus because the memory chip 21 at the third tier is a defective product and cannot be repaired, or still fails to pass an electrical test after being repaired. A tier address of the memory chip 21 at the third tier is recorded on the bus of the high bandwidth memory in this embodiment of this application. For the memory chip 21 at the third tier that is marked as a defective product and shielded, data access of the memory chip 21 at the third tier can be skipped through address marking. In this way, in an implementation, if a capacity of each tier of memory chip 21 is 2 Gbit, a high bandwidth memory that is a good product should have a memory capacity of 8 Gbit. However, for the conventional technology, in a production process, when a memory chip 21 at any one tier is a defective product, the entire high bandwidth memory can only be discarded as failed and unavailable product. This manner causes a great waste of costs because a yield rate is not high. According to the high bandwidth memory provided in this embodiment of this application, a memory chip 21 marked as a defective product can be addressed and shielded by using a tier address recorded on a bus. As shown in FIG. 14, when the memory chip 21 at the third tier is marked as a defective product, addressing and shielding processing may be performed on the memory chip 21 at the third tier before the wafer to wafer stacking structure is cut, so that in the high bandwidth memory formed through cutting, data is not accessed by the memory chip 21 marked as a defective product at this tier, and the high bandwidth memory can implement theoretical tier reduction (because in an actual physical structure, a tier at which the defective memory chip 21 is located is not actually reduced, this is referred to as theoretical tier reduction). Three tiers of available memory chips 21 are used, and the memory capacity is 6 Gbit for normal use. Therefore, a production yield rate of the high bandwidth memory is improved, and production costs of the high bandwidth memory are reduced.

Similarly, in another implementation, for the high bandwidth memory in this embodiment of this application, when there are another quantity of tiers of memory chips 21 stacked on the logic chip 11, and there are more than one tier of memory chip 21 marked as defective products, this manner may be used for shielding and reducing tiers for use. Principles of manners of testing, shielding, cutting, and using are the same as those in the foregoing example, and details are not described herein again.

Embodiments of this application provide a wafer to wafer stacking structure and a test method therefor, and a high bandwidth memory and a production method therefor. An actual available memory capacity in the high bandwidth memory obtained through cutting is adjusted through testing, addressing, and shielding or repairing of a cut unit in the wafer to wafer stacking structure after the test, so that a plurality of types of high bandwidth memories with a part of capacity reduced are provided. Therefore, production efficiency and a production yield rate of the high bandwidth memory are improved, and production costs of the high bandwidth memory are reduced.

The foregoing descriptions are merely specific implementations of embodiments of this application, but are not intended to limit the protection scope of embodiments of this application. Any variation or replacement readily figured out by a person skilled in the art within the technical scope disclosed in the present invention shall fall within the protection scope of embodiments of this application. Therefore, the protection scope of embodiments of this application shall be subject to the protection scope of the claims.

## Claims

1. A test method for a wafer to wafer stacking structure, wherein the method is applied to a test machine, the test machine is configured to test the wafer to wafer stacking structure, the wafer to wafer stacking structure comprises a logic wafer and a plurality of tiers of memory wafers, wherein the logic wafer and the plurality of tiers of memory wafers are stacked in sequence, the logic wafer is connected to the plurality of tiers of memory wafers through a bus, the logic wafer comprises a tier address port for transmitting a tier address to the plurality of tiers of memory wafers through the bus, and an addresser of the test machine is configured to connect to the logic wafer; and the method comprises:
obtaining a to-be-tested three-dimensional tier-number address, wherein the three-dimensional tier-number address is used to indicate a tier address corresponding to each of the plurality of tiers of memory wafers; and
reading, by the addresser based on the three-dimensional tier-number address through the tier address port of the logic wafer and the bus, probe information of a memory wafer having a tier address corresponding to the three-dimensional tier-number address, wherein the probe information is used to indicate quality of a cut unit on the memory wafer corresponding to the three-dimensional tier-number address.

2. The test method for a wafer to wafer stacking structure according to claim 1, wherein after the reading, by the addresser, based on the three-dimensional tier-number address through the tier address port of the logic wafer and the bus, probe information of a memory wafer having a tier address corresponding to the three-dimensional tier-number address, the method further comprises:
outputting repair indication information based on the probe information, wherein the repair indication information is used to indicate information about a repairable location in the cut unit.

3. The test method for a wafer to wafer stacking structure according to claim 2, wherein the probe information comprises an identifier of the cut unit, a quantity of failure memory units in a memory area of each cut unit, and location information of the failure memory unit, wherein the identifier of the cut unit is used to indicate a two-dimensional row address and a two-dimensional column address of the cut unit.

4. The test method for a wafer to wafer stacking structure according to claim 3, wherein the probe information further comprises a quantity of redundancy memory units in each cut unit; and
the outputting repair indication information based on the probe information comprises:
determining, based on the quantity of failure memory units in the memory area of each cut unit and the quantity of redundancy memory units in each cut unit, whether the cut unit is repairable; and
when the cut unit is repairable, outputting the repair indication information.

5. The test method for a wafer to wafer stacking structure according to claim 4, wherein the outputting repair indication information comprises:
when the cut unit is repairable, determining location information of a repairable memory unit in the repairable cut unit; and
outputting the location information of the repairable memory unit in the repairable cut unit.

6. The test method for a wafer to wafer stacking structure according to claim 4, wherein after the determining, based on the quantity of failure memory units in the memory area of each cut unit and the quantity of redundancy memory units in each cut unit, whether the cut unit is repairable, the method further comprises:
when the cut unit is irreparable, determining that the cut unit is a defective product, and outputting an identifier of the defective product.

7. A production method for a high bandwidth memory, wherein the high bandwidth memory is obtained by cutting a wafer to wafer stacking structure, the wafer to wafer stacking structure comprises a logic wafer and a plurality of tiers of memory wafers, wherein the logic wafer and the plurality of tiers of memory wafers are stacked in sequence, the logic wafer is connected to the plurality of tiers of memory wafers through a bus, and the logic wafer comprises a tier address port for transmitting a tier address to the plurality of tiers of memory wafers through the bus; and the method comprises:
obtaining probe information output by a test machine, wherein the probe information is used to indicate quality of a cut unit on a memory wafer tested based on a three-dimensional tier-number address and a corresponding tier address;
adjusting a connection status of the cut unit in the wafer to wafer stacking structure based on the probe information, wherein the connection status comprises a signal connection relationship between the cut unit and another cut unit located at an adjacent tier; and
cutting an adjusted wafer to wafer stacking structure to obtain the high bandwidth memory, wherein the high bandwidth memory comprises a cut unit of the logic wafer and a cut unit of each stacked memory wafer.

8. The production method for a high bandwidth memory according to claim 7, wherein the probe information comprises an identifier of the cut unit, a quantity of failure memory units in a memory area of each cut unit, and location information of the failure memory unit, wherein the identifier of the cut unit is used to indicate a two-dimensional row address and a two-dimensional column address of the cut unit.

9. The production method for a high bandwidth memory according to claim 8, wherein the probe information further comprises a quantity of redundancy memory units in each cut unit; and
before the cutting an adjusted wafer to wafer stacking structure to obtain the high bandwidth memory, the method further comprises:
determining location information of a repairable memory unit in a repairable cut unit based on the quantity of failure memory units in the memory area of each cut unit and the quantity of redundancy memory units in each cut unit; and
locating the repairable memory unit based on the location information of the repairable memory unit, bypassing a circuit of the repairable memory unit, and correspondingly connecting the repairable memory unit to the redundancy memory unit.

10. The production method for a high bandwidth memory according to any one of claims 7 to 9, wherein the adjusting a connection status of the cut unit in the wafer to wafer stacking structure based on the probe information comprises:
shielding a cut unit indicated as a defective product in the probe information.

11. A wafer to wafer stacking structure, comprising a logic wafer and a plurality of tiers of memory wafers, wherein the logic wafer and the plurality of tiers of memory wafers are stacked in sequence, the logic wafer and the plurality of tiers of memory wafers are connected through a bus, and the logic wafer comprises a tier address port.

12. The wafer to wafer stacking structure according to claim 11, wherein the bus records a tier address of each memory wafer, and the tier address port on the logic wafer is configured to transmit the tier address of each memory wafer.

13. A high bandwidth memory, comprising a logic chip and a plurality of tiers of memory chips, wherein the logic chip and the plurality of tiers of memory chips are stacked in sequence, the logic chip and the plurality of tiers of memory chips are connected through a bus, the bus records a tier address of each memory chip, and the logic chip comprises a tier address port for transmitting a tier address to the plurality of tiers of memory chips through the bus.

14. The high bandwidth memory according to claim 13, wherein the plurality of tiers of memory chips comprise at least one tier of shielded memory chip.
